# EUROPÄISCHE PATENTSCHRIFT

(11) **EP 0 524 227 B1**
(45) Veröffentlichungstag und Bekanntmachung des Hinweises auf die Patenterteilung: **17.08.1994**
(21) Anmeldenummer: 91907459.1
(22) Anmeldetag: 03.04.1991
(51) Int. Cl.: G11B 20/14, H04L 25/49

(54) **AUSWERTESCHALTUNG FÜR EIN BINÄRSIGNAL**
A DEVICE FOR EVALUATING A BINARY SIGNAL
DISPOSITIF POUR EVALUER UN SIGNAL BINAIRE

(30) Priorität: 12.04.1990 DE 4011894
(43) Veröffentlichungstag der Anmeldung: 27.01.1993
(73) Patentinhaber: Deutsche Thomson-Brandt GmbH, 78003 Villingen-Schwenningen (DE)
(72) Erfinder: SCHOLZ, Werner, D-3007 Gehrden (DE)
(86) Internationale Anmeldenummer: EP9100634
(87) Internationale Veröffentlichungsnummer: WO9116710

(56) Entgegenhaltungen:
- EP-A- 0 058 081
- EP-A- 0 143 005
- DE-A- 3 500 115
- DE-A- 3 526 051
- IBM TECHNICAL DISCLOSURE BULLETIN. vol.29, No. 1, June 1986 New York US, pages 151-157; "Fault Tolerant Sync Byte for run - length- limited codes"

## Beschreibung

Die Erfindung geht aus von einer Answerteschaltung gemäß dem Oberbegriff des Anspruchs 1.

Eine solche Schaltung ist z.B. aus DE-A-3526051 bekannt.

Für die Aufzeichnung digitaler Signale z.B. CD, R-DAT, DVS, DVT ist es üblich, ein NRZI-Signal aufzuzeichnen. Im NRZI-Signal wird die logische "1" durch einen Pegelübergang gekennzeichnet. Dadurch wird die übertragene Information von der Signalpolarität unabhängig. Dieses ist der eigentliche Vorteil der NRZI-Aufzeichnung. Bei dem obengenannten Aufzeichnungsverfahren wird eine sogenannte m/n-Modulation angewendet. Dabei werden jedem m-bit-Datenwort ein oder mehrere n-bit-Codewörter zugeordnet, wobei n > m ist. Bei der CD werden 8-bit-Datenworten, 14-bit-Codewörter zugeordnet. Beim Zusammensetzen des codierten Signals werden zwecks Einhaltung der runlength- und DC-Bedingungen zwischen zwei Codeworten noch jeweils 3 zusätzliche Bits eingefügt, so daß auf 8 Datenbits jeweils 17 Bits im codierten Signal kommen (vgl. z.B. EP-A-58 081)

Ein durch eine Tabelle festgelegter m/n-Code besitzt den Vorteil, daß eine Fehlerfortpflanzung vermieden wird. Dieser Vorteil bleibt bei der CD erhalten, obwohl ein NRZI-Signal aufgezeichnet wird, da zwischen den einzelnen Codewörtern zusätzliche Bits angeordnet sind. Bei den übrigen genannten Aufzeichnungsverfahren wird die 8/10-Modulation ohne zusätzliche Bits zwischen den Codewörtern angewendet. Wenn aber kein Zusatzbit zwischen den Codewörtern eingefügt wird, führt die NRZI-Wandlung zu einem Signal, das nicht mehr frei von Fehlerfortpflanzung ist. Wenn nämlich im wiedergegebenen Signal das letzte Bit eines in NRZI aufgezeichneten Codewortes gestört ist, dann wird bei der Rückwandlung der Codewörter in NRZ auch das erste Bit des nachfolgenden Codewortes umgekehrt. Bei der 8/10-Demodulation entstehen somit durch ein falsches Bit im abgetasteten Signal zwei falsche Bytes im demodulierten Signal. Diese Fehlerfortpflanzung tritt bei 8/10-Modulation bei ca 10 % aller Bitfehler auf. Aus diesem Grund sollte die m/n-Modulation ohne NRZI-Wandlung angewendet werden, sofern keine Zusatzbits zwischen den Codewörtern verwendet werden.

Der Erfindung liegt die Aufgabe zugrunde, eine Fehlerfortpflanzung von einem Codewort in das nächste Codewort zu vermeiden und trotzdem den durch die NRZI-Wandlung gegebenen Vorteil der Polaritätsunabhängigkeit zu erhalten.

Diese Aufgabe wird durch die im Anspruch 1 angegebene Erfindung gelöst. Vorteilhafte Weiterbildungen der Erfindung sowie eine andere Möglichkeit zur Lösung der Aufgabenstellung sind in den Unteransprüchen angegeben.

Die Verwendung von Synchronisationsworten mit festem Bitmuster ist bekannt (DE-A-3500115).

Nach Ermittlung der Signalpolarität kann durch ein EXOR-Gatter dann dafür gesorgt werden, daß dem Demodulator-Eingang das übertragene Signal stets mit der richtigen Polarität zugeführt wird.

Eine andere Möglichkeit zur Vermeidung der Polaritätsabhängigkeit des Signals besteht darin, statt des m/n-Codes einen m/(n-1)-Code zu verwenden und ein zusätzliches Bit zwischen den Codewörtern einzufügen. Dieser Code kann als NRZI-Signal aufgezeichnet und wieder nach NRZ demoduliert werden, ohne daß die Gefahr einer Fehlerfortpflanzung entsteht.

Die Erfindung wird im folgenden anhand der Zeichnung an einem Ausführungsbeispiel erläutert.
- Fig. 1: zeigt am Ausschnitt aus einer R-DAT-Datenübertragung, wie durch einen Bitfehler zwei Bytefehler verursacht werden.
- Fig. 2: zeigt eine Schaltung zur Polaritätskorrektur eines NRZ-Signals. Die Schaltung dient gleichzeitig zur Synchronsignalerkennung.
- Fig. 3: zeigt die Signalverläufe zur Erklärung der Schal tung nach Fig. 2.

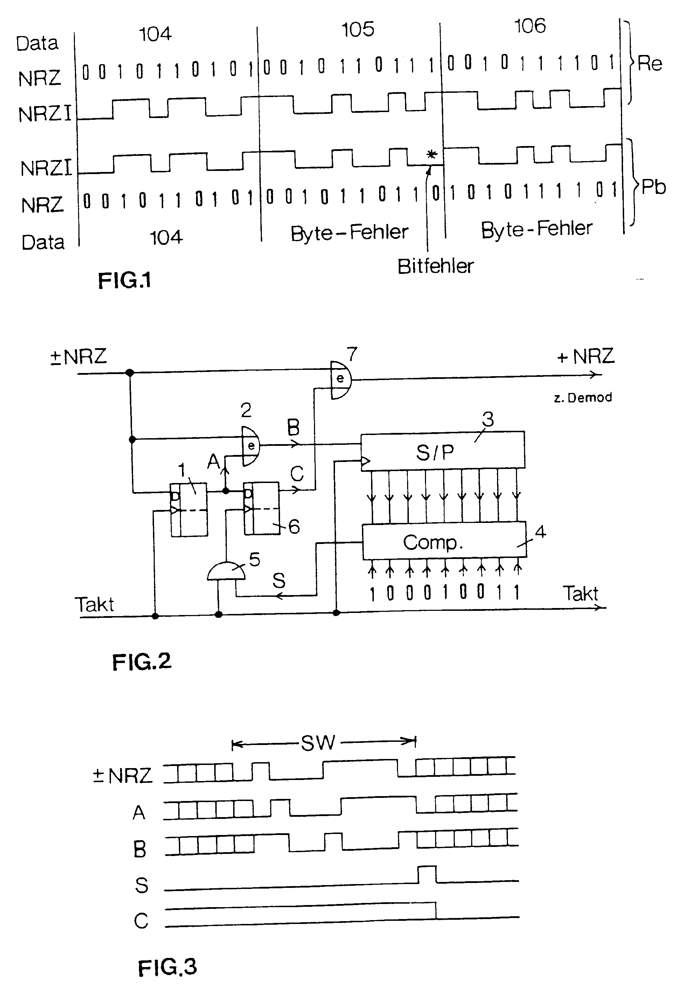

Den Eingängen der Schaltung nach Fig. 2 werden ein NRZ-Signal mit unbestimmter Polarität und der zugehörige Bittakt zugeführt. Das NRZ-Signal enthält im Einlaufsignal oder auch über das übrige Signal verteilt festgelegte Bitmuster SW, aus denen die korrekte Signalpolarität erkennbar ist. Diese Muster können gleichzeitig zur Blocksynchronisierung dienen.

In der Schaltung wird zunächst mit Hilfe des D-Flip-Flops 1 und des EXOR-Gatters 2 die Spannung B gewonnen, deren Verlauf von der Polung des Eingangssignals unabhängig ist. Damit ist das Bitmuster, das die Ermittlung der Signalpolarität auslöst, unabhängig von dieser erkennbar. Dieses Muster SW besteht hier aus 10 Bit bzw. am Ausgang des Gatters 2 aus 9 Bit (Signal B). Zur Erkennung des Musters dient der S/P-Wandler 3 und der Comparator 4. Der Ausgang des Comparators geht auf high, sobald das letzte Bit des Musters B in den S/P-Wandler eingelesen ist, für die Dauer eines Bits (Signal S). Diese Zeit fällt mit dem letzten Bit des Musters SW am Ausgang A zusammen. Der Wert dieses Bit wird im Flip-Flop 6 gespeichert (Signal C) und stellt mit Hilfe des EXOR-Gatters 7 die richtige Polarität des NRZ-Signals ein.

Die in Fig. 3 dargestellten Signale gelten für den Fall, daß das Eingangssignal bereits die richtige Polarität hat.

## Patentansprüche

1. Auswertschaltung für ein Binärsignal, bei dem Kennsignale (SW) übertragen werden, die eine Polaritätsbestimmung des Binärsignals ermöglichen, **dadurch gekennzeichnet**, daß durch Auswertung der Pegelübergänge die zeitliche Lage des Kennsignals (SW) unabhängig von der Polarität des Binärsignals erkannt und daß aus dieser zeitlichen Lage der Abtastzeitpunkt eines bestimmten, zusammen mit dem Kennsignal übertragenen Bits mit vorgegebenem Wert zur Feststellung der momentanen Signalpolarität abgeleitet wird und dessen Wert durch Abtastung ermittelt wird.

2. Schaltung nach Ansruch 1, **dadurch gekennzeichnet**, daß durch Verwendung eines Zeitfensters für das Kennsignal Fehlauswertungen durch Bitmuster, die das Kennsignal vortäuschen, vermieden werden.

3. Schaltung nach Anspruch 1, **dadurch gekennzeichnet**, daß nach Einstellung der richtigen Polarität, die z.B. durch eine Fehlererkennungsschaltung bestätigt wird, die Polaritätseinstellung bis zu einem neuen Signalabschnitt unveränderbar ist.

4. Schaltung nach Anspruch 1, 2 oder 3, **dadurch gekennzeichnet**, daß die Schaltung mit der Schaltung zur Synchronsignalerkennung kombiniert ist.

5. Schaltung nach einem oder mehreren der Ansprüche 1 bis 4, **dadurch gekennzeichnet,** daß die Polaritäseinstellung des Binärsignals mit Hilfe eines EXOR-Gatters (7) erfolgt.

## Claims

1. Evaluation circuit for a binary signal in which code signals (SW) are transmitted, which enable determination of the polarity of the binary signal, **characterized in that**, by evaluating the level transitions, the time position of the code signal (SW) is recognized independently of the polarity of the binary signal and that from said time position is derived the sampling instant of a specific bit of a predetermined value transmitted together with the code signal for establishing the instantaneous signal polarity and its value is determined by sampling.

2. Circuit according to claim 1, **characterized in that**, by using a time window for the code signal, spurious evaluations caused by bit patterns which simulate the code signal are avoided.

3. Circuit according to claim 1, **characterized in that**, after adjustment of the correct polarity which is confirmed, for example, by an error detection circuit, the polarity setting is invariable up to a new signal segment.

4. Circuit according to claim 1, 2 or 3, **characterized in that** the circuit is combined with the circuit for synchronizing signal detection.

5. Circuit according to one or more of claims 1 to 4, **characterized in that** adjustment of the polarity of the binary signal is effected with the aid of an exclusive OR gate (7).

## Revendications

1. Circuit d'exploitation pour un signal binaire dans lequel des signaux d'identification (SW) sont transmis qui permettent une détermination de la polarité du signal binaire, **caractérisé en ce** que par l'exploitation des transitions de niveau la position temporelle du signal d'identification (SW) est reconnue indépendamment de la polarité du signal binaire et qu'à partir de cette position temporelle le moment d'exploration d'un bit déterminé, transmis avec le signal d'identification, avec une valeur prédéterminée est dérivé pour constater la polarité momentanée du signal et dont la valeur est déterminée par exploration.

2. Circuit selon la revendication 1, **caractérisé en ce** que des erreurs d'exploitation dûes à des profils binaires qui simulent le signal d'identification sont évitées grâce à l'utilisation d'une fenêtre de temps pour le signal d'identification.

3. Circuit selon la revendication 1, **caractérisé en ce** qu'après réglage de la polarité correcte qui est confirmée par exemple par un circuit de reconnaissance d'erreurs, le réglage de la polarité est invariable jusqu'à une nouvelle section de signal.

4. Circuit selon la revendication 1, 2 ou 3, **caractérisé en ce** que le circuit est combiné au circuit pour la reconnaissance du signal de synchronisation.

5. Circuit selon l'une ou plusieurs des revendications 1 à 4, **caractérisé en ce** que le réglage de la polarité du signal binaire est effectué à l'aide d'un élement OU exclusif (7).
